# EUROPÄISCHE PATENTSCHRIFT

(11) **EP 2 359 152 B1**
(45) Veröffentlichungstag und Bekanntmachung des Hinweises auf die Patenterteilung: **04.07.2018**
(21) Anmeldenummer: 09778735.2
(22) Anmeldetag: 25.09.2009
(51) Int. Cl.: G01R 13/02, G01R 23/18

(54) **DARSTELLEN VON SPEKTREN**
DISPLAY OF SPECTRA
REPRÉSENTATION DE SPECTRES

(30) Priorität: 17.12.2008 DE 102008062696
(43) Veröffentlichungstag der Anmeldung: 24.08.2011
(73) Patentinhaber: Rohde & Schwarz GmbH & Co. KG, 81671 München (DE)
(72) Erfinder: HISCH, Martin, 85661 Forstinning (DE)
(74) Vertreter: Beder, Jens
(86) Internationale Anmeldenummer: PCT/EP2009/006950
(87) Internationale Veröffentlichungsnummer: WO 2010/069414

(56) Entgegenhaltungen:
- EP-A1- 0 962 778
- EP-A1- 1 927 862
- EP-A2- 0 398 042
- WO-A1-2008/064752
- US-A- 4 870 348
- MEES J: "SCHNELLES ANALYSIEREN VON ANOMALIEN IN HF-SIGNALEN" NTZ (NACHRICHTENTECHNISCHE ZEITSCHRIFT), VDE VERLAG GMBH, DE, Bd. 59, Nr. 7/08, 1. November 2006 (2006-11-01), Seiten 14-17, XP001249756 ISSN: 0948-728X

## Beschreibung

Die Erfindung betrifft ein Messgerät sowie ein Verfahren zur Messdatenverarbeitung.

Messgeräte zur Analyse von Spektren messen und berechnen eine Größe, wie z.B. Leistung oder Phase, eines Messsignals in Abhängigkeit der Frequenz. Ein typischer Vertreter solcher Messgeräte ist der Spektralanalysator, der ein Leistungsspektrum eines Eingangssignals misst. Das Leistungsspektrum wird jeweils für nacheinander liegende kleine Zeitfenster des Eingangssignals berechnet oder direkt gemessen, so dass eine zeitliche Entwicklung des Leistungsspektrums des Eingangssignals analysierbar ist. Die zeitlich nacheinander gemessenen Spektren werden normalerweise nacheinander auf einen Bildschirm gegeben, um eine zeitliche Entwicklung des Spektrums darzustellen.

Durch das Nachleuchten und durch eine Proportionalität zwischen Farbintensität und der Anzahl an überlagerten Funktionen an einem Punkt in analogen Bildschirmen wurde für den Benutzer eines Spektralanalysators eine Überlagerung der letzten Spektren sichtbar. Durch die positive Überlagerung gleicher Spektralwerte der Spektren wurden stationäre Signale von Kurzzeitsignalen und Rauschen unterscheidbar und der Benutzer hatte aus einer einfachen Darstellung einen relativ hohen Wissensgewinn.

Digitale Bildschirme zeigen diese positiven Eigenschaften nicht. Werden die Spektren hier aufeinanderfolgend auf ein digitales Display gegeben, wechseln die Spektren schneller als das Auge dies aufnehmen kann, da der Zeitabstand zwischen zwei aufeinanderfolgend gemessenen Spektren wesentlich geringer als das zeitliche Auflösungsvermögen des Auges ist. Lässt man die Spektren länger als bis zum darauffolgend dargestellten neuen Spektrum auf dem Bildschirm, um einen oben beschriebenen Effekt einer analogen Darstellungseinrichtung zu erhalten, sammeln sich eine bestimmte Anzahl an Spektren auf dem Bildschirm an, die nicht mehr unterscheidbar und zuzuordnen sind, da alle insgesamt auftretenden Spektralwerte der Anzeige die gleiche Intensität oder Farbe haben.

Die deutsche Offenlegungsschrift DE 10 2004 040 473 A1 offenbart einen digitalen Leuchtstoff-Spektralanalysator, der auf einem digitalen Bildschirm eines Spektralanalysators das Verhalten und Aussehen eines analogen Bildschirms emuliert. Dabei wird eine gewisse Menge an zuletzt gemessenen Spektren gesammelt und die Werte der Spektren alle gleichzeitig auf dem Bildschirm dargestellt. Die Farbintensität der dargestellten Spektralwerte auf dem Bildschirm ist dabei proportional zu der Anzahl des Auftretens dieses jeweiligen Spektralwertes in den verschiedenen gemessenen Spektren. Die Farbintensität der Darstellungspunkte kann entsprechend eines komplexen Algorithmus zwischen den Darstellungspunkten des jeweiligen Spektrums verteilt werden. Die Farbintensität der Gesamtheit der dargestellten Spektren wird zusätzlich noch mit einer Abklingfunktion reduziert, um ein möglichst analogähnliches Bildschirmbild zu erzeugen.

Nachteilig an dem digitalen Leuchtstoff-Spektralanalysator ist, dass die Verteilung der Farbintensität zwischen den Darstellungspunkten sehr komplex und aufwendig ist. Dies führt zu einer kostenintensiveren Bildverarbeitung, da eine schnellere Hardware zu Berechnung der Darstellungsdaten nötig ist. Würden andererseits nur die Darstellungspunkte dargestellt, ohne diese zu verbinden, würden gerade sehr schmalbandige stationäre Signale, die im Frequenzbereich nur aus einem oder zwei Bildpunkten bestehen kaum sichtbar, da ein Pixel normalerweise eine Größe von 0,028 mm aufweist.

Würden andererseits die Spektren vektoriell dargestellt, d.h. die Darstellungspunkte miteinander verbunden, ist ein stationäres, schmalbandiges Signal klar zu erkennen. Allerdings lassen sich dadurch neben dem stationären, schmalbandigen Signal auftretende rauschartige Signale nicht mehr erkennen, da die rauschartigen Signale der überlagerten Spektren alle in einem ähnlichen Leistungsbereich liegen und sich mehrfach kreuzen, so dass letztendlich kein Spektrum mehr zuzuordnen ist.

Diese rauschartigen Signale sind auch nicht durch die zur Auftrittshäufigkeit der Spektralwerte proportionale Intensitätsdarstellung erkennbar, da ihre Spektralwerte sich kaum wiederholen. Somit sind Kurzzeitsignale, die in diesem Leistungsbereich liegen, kaum vom Rauschen der vorangegangenen und den nachfolgenden Spektren zu unterscheiden.

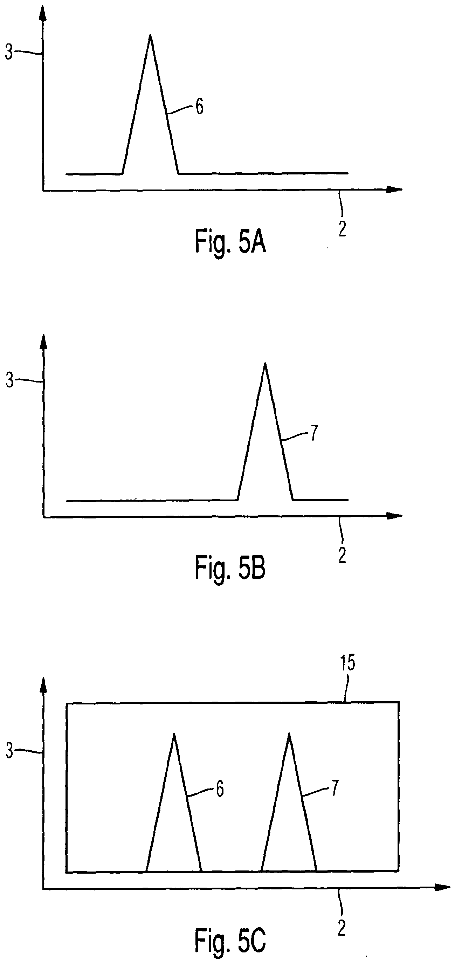

Weiterhin nachteilig ist, dass zwei verschiedene Spektren, die in zwei unterschiedlichen Zeitbereichen innerhalb des Akkumulationszeitbereichs der Spektren ähnlich lange auftreten, nicht mehr unterscheidbar sind, da sie die gleiche Farbintensität aufweisen. Dies ist in den Fig. 5A, 5B und 5C dargestellt, wobei Fig. 5A und 5B jeweils ein aufgenommenes Einzelspektrum 6 und 7 mit einem unterschiedlichen Verlauf als Amplitude oder Leistung 3 über die Frequenz 2 zeigt. Wenn die beiden Spektren 6 und 7 nun innerhalb der Sammelzeit aufgenommen werden und die Spektren 6 und 7 in etwa gleich lang das Messsignal repräsentieren, haben die Spektren 6 und 7 in dem Darstellungsmodus des Stands der Technik die gleiche Intensität, da sie gleich oft gemessen wurden. Dadurch erscheinen zwei zeitlich verschoben auftretende, verschiedene Spektren 6 und 7 auf dem in Fig. 5C dargestellten Bildschirm des Spektrumsanalysators des Stands der Technik als ein aus beiden Spektren 6 und 7 überlagertes Spektrum. Die einzelnen Spektren 6 und 7 sind nicht mehr voneinander unterscheidbar.

Die Aufgabe der Erfindung ist es, die Probleme des Stands der Technik zu lösen. Die Darstellungsdaten der Spektren sollen so berechnet werden, dass die Darstellungsdaten die Anzahl des Auftretens der gleichen Spektralwerte wiedergibt, sowohl schmalbandige, stationäre Signale als auch Kurzzeit- und rauschartige Signale erkennbar sind und eine schnelle und einfache Berechnung der Darstellungsdaten realisierbar ist.

Die Aufgabe ist durch ein erfindungsgemäßes Verfahren nach Anspruch 1 und durch ein erfindungsgemäßes Messgerät nach Anspruch 5 gelöst.

In dem erfindungsgemäßen Verfahren zur Messdatenverarbeitung wird zuerst eine Mehrzahl von Einzelspektren eines Signals in einem bestimmten Zeitintervall gemessen. Die Messung kann dabei eine beliebige physikalische Größe, die von der Frequenz des zu messenden Signals abhängt, betreffen. Alle Einzelspektren aus dem bestimmten Zeitintervall werden über die Frequenz auf einem digitalen Bildschirm als Anzeigevorrichtung gleichzeitig dargestellt und die auftretenden Spektralwerte in Abhängigkeit der Anzahl ihres Auftretens in den verschiedenen Einzelspektren optisch unterscheidbar dargestellt. Ein Hilfsspektrum wird aus einem oder mehreren der Einzelspektren gebildet und das Hilfsspektrum auf dem digitalen Bildschirm optisch unterscheidbar zu den akkumulierten Spektren dargestellt.

Ein erfindungsgemäßes Messgerät weist eine Messvorrichtung zum Messen einer Mehrzahl von Einzelspektren eines Signals und eine Anzeigevorrichtung zur Darstellung von Spektren über die Frequenz auf. Zusätzlich weist das Messgerät eine Steuervorrichtung verbunden mit der Anzeigevorrichtung und der Messvorrichtung zur Berechnung der Darstellungsdaten aus den gemessenen Einzelspektren der Messvorrichtung auf. Die Steuervorrichtung weist eine Akkumulationsvorrichtung auf, die mehrere Einzelspektren aus einem bestimmten Zeitbereich sammelt und Darstellungsdaten aus den Einzelspektren für die Anzeigevorrichtung berechnet, so dass die Spektralwerte der Einzelspektren aus dem bestimmten Zeitbereich auf dem Display gleichzeitig über der Frequenz darstellbar sind und die auftretenden Spektralwerte verschiedener Einzelspektren in Abhängigkeit von der Anzahl ihres Auftretens optisch unterscheidbar darstellbar sind. Die Steuervorrichtung weist weiterhin eine Auskoppelvorrichtung zur Auskoppelung von Einzelspektren der Messvorrichtung vor dem Eingang der Akkumulationsvorrichtung auf. Zusätzlich weist die Steuervorrichtung eine Hilfsspektrumserzeugungsvorrichtung verbunden mit der Auskoppelvorrichtung zum Bilden eines Hilfsspektrums aus einem oder mehreren der Spektren und zur Berechnung von Darstellungsdaten aus dem Hilfsspektrum auf, so dass das Hilfsspektrum auf der Anzeigevorrichtung optisch unterscheidbar zu den akkumulierten Spektren darstellbar ist. Die Erfindung betrifft insbesondere digitale Bildschirme, wie z.B. TFT-Displays. Nachfolgend wird daher anstelle des Begriffs Anzeigevorrichtung die Bezeichnung digitaler Bildschirm verwendet. Eine Einkoppelvorrichtung der Steuervorrichtung ist zwischen der Akkumulationsvorrichtung und dem digitalen Bildschirm angeordnet und ist mit der Hilfsspektrumserzeugungsvorrichtung zum Vereinen der Darstellungsdaten des Hilfsspektrums mit den Darstellungsdaten der Einzelspektren verbunden.

Vorteilhaft an dem erfindungsgemäßen Verfahren und an der erfindungsgemäßen Messvorrichtung ist es, dass es sehr einfach ist, ein Hilfsspektrum optisch unterscheidbar von den anderen gleichzeitig dargestellten Einzelspektren darzustellen. Je nach Wahl des Hilfsspektrums kann ein bereits vorhandenes, aber optisch nicht unterscheidbares Spektrum hervorgehoben werden oder auch ein aus den Einzelfaktoren gemitteltes Spektrum als Hilfsspektrum hervorgehoben werden. Durch ein ausgewähltes Einzelspektrum als Hilfsspektrum lassen sich z.B. Kurzzeit- und rauschartige Signale in dem niedrigen Leistungsbereichen eines Spektralanalysators erkennen.

Die Unteransprüche betreffen vorteilhafte Weiterbildungen der Erfindung.

So ist es besonders vorteilhaft, die gleichzeitig dargestellten Einzelspektren jeweils als Punkte über die Frequenz darzustellen und die Anzahl des Auftretens der Spektralwerte in der Gesamtheit der verschiedenen Einzelspektren durch Verwendung verschiedener Farben einer Farbskala für unterschiedliche Anzahlen darzustellen. Das Hilfsspektrum wird vorteilhafterweise in einer nicht in der Farbskala der Spektralwertehäufigkeit vorkommenden Farbe dargestellt. Unterschiedliche Farben sind optisch besonders gut unterscheidbar.

Unter verschiedenen Farben sind allgemein nicht nur Farben im Sinne von unterschiedlichen Wellenlängen im sichtbaren Bereich, sondern auch verschiedene Helligkeitswerte der gleichen Farbe und verschiedene Muster gemeint. Optisch unterscheidbar bezieht sich dabei auf den optischen Bereich, der für das menschliche Auge aufnehmbar ist.

Werden die Darstellungspunkte des Hilfsspektrums interpoliert, sind auch schmalbandige stationäre Signale im Frequenzspektrum gut sichtbar, ohne alle Einzelspektren aufwendig interpolieren zu müssen und somit auch die Darstellung im niedrigen und verrauschten Leistungsbereich eines Spektralanalysators durch die vielen sich ständig überkreuzenden Spektrallinien unübersichtlich gestalten zu müssen.

Besonders vorteilhaft ist es, wenn mehrere Hilfsspektren gleichzeitig dargestellt sind. Dadurch können mehrere Spektren hervorgehoben werden, ohne wiederum alle Spektren gleich darzustellen. Z.B. durch die Darstellung mehrerer, in bestimmten Zeitabständen aufgenommener Einzelspektren kann eine zeitlich Entwicklung oder Historie des Spektrums des Eingangssignals der Messvorrichtung hervorgehoben werden.

Werden die Hilfsspektren optisch unterscheidbar dargestellt und wird die Farbe entsprechend einer seit der Messung des Einzelspektrums vergangenen Zeit gewählt, kann die Dynamik des Spektrums des Messsignals besonders gut dargestellt werden.

Ein Ausführungsbeispiel der Erfindung wird nachstehend anhand der Zeichnung beschrieben. Die Zeichnung zeigt:
- Fig. 1: eine schematische Darstellung eines Ausführungsbeispiels der erfindungsgemäßen Messvorrichtung;
- Fig. 2: ein Blockdiagramm der Schritte eines Ausführungsbeispiels des erfindungsgemäßen Verfahrens;
- Fig. 3: ein Ausführungsbeispiel für die Aufbereitung der Spektraldaten für den Bildschirm der erfindungsgemäßen Messvorrichtung;
- Fig. 4: ein weiteres Ausführungsbeispiel für die Aufbereitung der Spektraldaten für den Bildschirm des erfindungsgemäßen Messgeräts;
- Fig. 5A: ein zu einer ersten Zeit aufgenommenes erstes Einzelspektrum;
- Fig. 5B: ein zu einer zweiten Zeit aufgenommenes zweites Einzelspektrum;
- Fig. 5C: Aufbereitung der Darstellungsdaten der beiden Einzelspektren aus Fig. 5A und 5B des Stands der Technik.

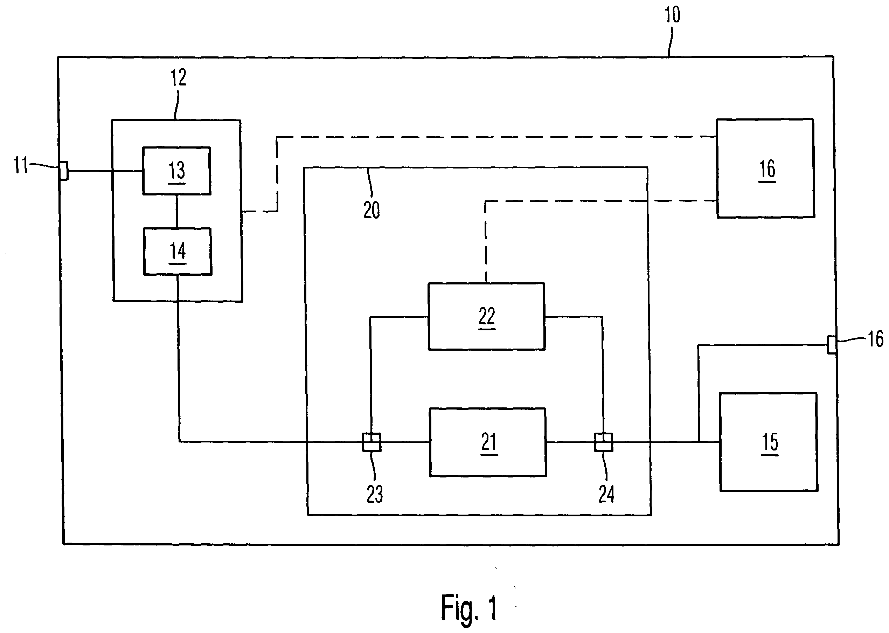

Fig. 1 zeigt ein Spektrumsanalysator 10 als spektrales Messgerät. Im dargestellten Ausführungsbeispiel ist die erfindungsgemäße Messvorrichtung in Form eines Messgeräts dargestellt. Es könnte jedoch ebenso eine Vorrichtung sein, bei der ein separater Bildschirm mit einer Messeinrichtung verbunden ist. Die Erfindung ist besonders vorteilhaft für einen Spektrumsanalysator 10 einsetzbar, insbesondere für einen Überwachungsempfänger zur Beobachtung von Empfangsspektren an Antennen. Dabei treten vor allem stationäre Signale in Kombination mit Kurzzeitsignalen auf, welche mit der Erfindung besonders gut analysierbar sind. Die Erfindung ist allerdings nicht auf Spektrumsanalysatoren beschränkt, sondern ist auf jedes Messgerät übertragbar, welches eine physikalische Größe in Abhängigkeit der Frequenz misst oder berechnet.

An einem Eingang 11 wird ein Messsignal angelegt und an eine Messeinrichtung 12 gegeben. Die Messeinrichtung 12 misst dabei die Leistung in Abhängigkeit der Frequenz und gibt die gemessenen Einzelspektren in festen Zeitabständen an ein Steuergerät 20. So kann zum Beispiel das Messsignal über einen Analog/Digital Wandler 13 digitalisiert werden und in digitaler Form an einen Spektrumsrechner 14 gegeben werden. Der Spektrumsrechner 14 berechnet auf der Basis eines Zeitfensters, welches z.B. die letzten 2048 Samplingpunkte des Messsignals enthält, ein Einzelspektrum auf der Basis eines gängigen Schätzers für das Leistungsspektrum, z.B. das Periodogramm. Der Schätzer kann dabei vom Benutzer über eine Eingabevorrichtung 16 ausgewählt werden, da je nach Art des Messsignals manche Schätzer besser geeignet sind. Die Daten des Leistungsspektrums werden als Einzelspektrum an die Steuervorrichtung 20 geschickt, während bereits die neu von dem Analog-/Digital-Wandler 13 angelieferten Datenpunkte in dem Spektrumsrechner 14 zwischengespeichert werden. Ist eine festgelegte Anzahl an neuen Samplingpunkten an den Spektrumsrechner 14 geschickt worden, kann aus den neuen oder teilweise neuen letzten 2048 Samplingpunkten des Messsignals ein neues Einzelspektrum berechnet werden, welches wiederum an die Steuervorrichtung 20 gegeben wird. So werden im Betrieb näherungsweise ohne Zeitverzögerung die Spektren des aktuell am Eingang 11 gemessenen Signals an die Steuervorrichtung 20 gegeben.

Über die Anzahl der Samplingpunkte für das Zeitfenster zur Spektrumsberechnung, über den Überlapp der Zeitfenster bzw. der Anzahl der Samplingpunkte, die das Zeitfenster weitergeschoben wird, und über die Samplingrate kann Qualität, Zeitauflösung und Frequenzauflösung der Einzelspektren entsprechend der Erfordernisse und des zu messenden Signals über die Eingabevorrichtung 16 eingestellt werden. Für die Erfindung ist vor allem die Anzahl der Samplingpunkte, die das Zeitfenster weitergeschoben wird, relevant, da die Anzahl multipliziert mit der Samplingrate des Messsignals die Zeit zwischen zwei aus dem Eingangssignal ermittelten Einzelspektren festlegt. Diese Zeit liegt in der Regel einige Größenordnungen unter dem Auflösungsvermögen des Auges.

Die Messeinrichtung 12 ist hier nur exemplarisch beschrieben und ist nicht beschränkend für die Erfindung. Es können auch mittels Heterodynempfängern Leistungen spezieller Frequenzen direkt gemessen werden und danach digitalisiert werden. Die Messeinrichtung 12 berechnet oder misst in regelmäßigen Zeitabständen ein Einzelspektrum, welches das Eingangsmesssignal zu diesem Zeitpunkt bzw. in diesem Zeitfenster repräsentiert, und gibt dieses in den gleichen regelmäßigen Abständen an die Steuervorrichtung 20. Wird eine andere spektrale Größe gemessen, wird in der Messvorrichtung 12 ein entsprechendes Spektrum dieser Größe gemessen oder berechnet und an die Steuervorrichtung 20 gegeben.

Die Einzelspektren werden in der Steuervorrichtung 20 in einer Akkumulationsvorrichtung 21 gespeichert. Dabei wird eine festgelegte Anzahl N an Spektren gespeichert. Nach dem Betriebsbeginn wird zuerst ein Speicher mit den N Einzelspektren vollgeschrieben und darauffolgend wird immer das älteste Einzelspektrum durch das neu gemessene Einzelspektrum von der Messvorrichtung 12 in dem Speicher der Akkumulationsvorrichtung 21 ersetzt. Somit stehen zu jedem Zeitpunkt die letzten N Spektren zur Verfügung.

In der Akkumulationsvorrichtung 21 werden nun die Darstellungsform und die Darstellungsdaten der gesammelten N Spektren für den digitalen Bildschirm 15 berechnet. Der digitale Bildschirm 15 weist eine gewisse Anzahl nx an Pixeln in der Richtung der x-Achse und eine gewisse Anzahl ny an Pixeln in der Richtung der y-Achse auf. Die Daten der Spektren, die als Leistungs-Frequenz-Tupel gespeichert sind, müssen in Bildschirmpunkte (x, y) umgerechnet werden, um auf dem digitalen Bildschirm durch Ansteuern des entsprechenden Pixels dargestellt werden zu können. Dazu werden den nx Pixeln oder einer Teilmenge davon Frequenzen von einer eingestellten Start- bis zur Stopfrequenz zugeordnet bzw. einem vergrößerten Frequenzbereich dazwischen zugeordnet. Damit entspricht jeder Pixel der nx Pixel oder der Teilmenge davon einem Frequenzwert. Die Messvorrichtung liefert pro Einzelspektrum eine Anzahl unabhängiger Leistungswert-Frequenz-Tupel. Da normalerweise mehr unabhängige Spektralwerte gemessen werden als Pixel nx auf dem Bildschirm zur Verfügung stehen, müssen den Pixelwerten x normalerweise mehrere Frequenzwerte bzw. ein Frequenzbereich zugeordnet werden und die zu den Frequenzwerten gehörenden Spektralwerte gemittelt oder auf andere Weise zusammengefasst werden. Für den seltenen Fall, dass weniger unabhängige Spektralwerte gemessen werden als Pixelwerte nx zur Verfügung stehen, können die Spektralwerte der Pixel ohne einen zugehörigen Spektralwert durch Interpolation oder durch eine Linearkombination der unabhängigen Fourierkoeffizienten, falls diese noch vorliegen, berechnet werden. Den ny Pixeln in der y-Richtung werden entsprechend Leistungswerte oder vorzugsweise logarithmierte Leistungswerte zwischen deren Minimum und Maximum oder in einem benutzerdefinierten Leistungsbereich zugeordnet. Die Umrechnung von Leistungs-Frequenz-Tupeln (A, f) in PixelTupel (x, y) kann dabei alternativ auch vor der Speicherung der Spektren, nach der Weiterverarbeitung der gesammelten Spektren oder auch erst kurz vor einem Bildschirm 15 geschehen.

Soll ein Einzelspektrum auf dem Bildschirm 15 dargestellt werden, kann nun jedes Pixeltupel (x, y), welches aus den Leistungs-Frequenz-Tupeln (A, f) eines jeden Einzelspektrums berechnet wurde, eine Farbe zugeordnet werden, um das Einzelspektrum optisch auf dem digitalen Bildschirm 15 sichtbar zu machen. Um nun alle gesammelten N Spektren darzustellen, werden pro xi Pixel, d.h. pro Pixelspalte i des digitalen Bildschirms, alle N Pixeltupel {(xi, yj) | j =1, ..., N} für jedes Einzelspektrum berechnet. D.h. es existieren pro x-Pixel N y-Pixelwerte als Spektralwerte A. Tritt nun ein Pixeltupel (x, y) mehrfach auf, wird dieses Pixeltupel in einer Farbe dargestellt, der die Anzahl des Auftretens dieses Pixeltupels (x, y) zugeordnet ist. Die Zuordnung zwischen Farbwert und Anzahl des Auftretens ist eindeutig. Der Benutzer kann z.B. auf dem Bildschirm neben den Darstellungsdaten noch eine Farbskala sehen, die die Häufigkeit eines Pixelpunktes oder deren Auftrittsanzahl mit einer Farbe verbindet und so den Spektralwerten eine Auftrittshäufigkeit zuordnen. Der Farbe des Anfangs der Farbskala wird das einfache Auftreten eines Spektralwertes zugeordnet, während der Farbe am Ende der Farbskala zum Beispiel das N-fache Auftreten oder das maximale Auftreten eines Spektralwertes zugeordnet sein kann. Zusammenfassend wird also ein Darstellungsbild aus den N gesammelten Spektren berechnet, welches alle N Spektren zeigt und die Anzahl des einfachen oder mehrfachen Auftretens eines Pixelpunktes bzw. eines entsprechenden Leistungswert-Frequenzwert-Tupels über eine Farbskala darstellt.

Die in der Steuervorrichtung 20 berechneten Darstellungsdaten werden zum Beispiel als Bitmap an den digitalen Bildschirm 15 und/oder über eine Schnittstelle 16 an einen externen digitalen Bildschirm gegeben, um die Darstellungsdaten anzuzeigen. Die Darstellungsdaten könnten theoretisch für jedes neue gelieferte Einzelspektrum neu berechnet und an den Bildschirm gegeben werden. Da aber die Messrate der Einzelspektren wesentlich höher ist als die Auflösungsrate des menschlichen Auges und da aufgrund der Vielzahl N an Einzelspektren, ein Einzelspektrum an dem Gesamtbild kaum eine erkennbare Änderung bewirkt, ist es besonders vorteilhaft, die Darstellungsdaten nur in einer Rate neu zu berechnen und an den Bildschirm zu geben, die im Bereich des Auflösungsverhaltens des menschlichen Auges liegt. So kann die Hardware für die Steuervorrichtung 20 und den digitalen Bildschirm 15 einfacher ausgeführt sein.

Über die Eingabevorrichtung 16, z.B. eine Maus, ein Touchscreen, eine Tastatur oder sonstige Eingabegeräte, kann der Benutzer Einstellungen, wie die Anzahl N der Spektren, die Berechnungsrate für die Darstellungsdaten, die Art der Farbskala für die Auftrittshäufigkeit der Spektralwerte, usw., vornehmen. Dadurch lassen sich die Darstellungsdaten an die Untersuchungsbedingungen und die Art des Messsignals anpassen.

Erfindungsgemäß wird nun vor der Akkumulationsvorrichtung 21 in der Steuervorrichtung 20 über eine Auskoppelvorrichtung 23, was zum Beispiel eine einfache Leitungsweiche oder -verzweigung sein kann, die Einzelspektren zusätzlich noch an eine Hilfsspektrumserzeugungsvorrichtung 22 geleitet. In der Hilfsspektrumserzeugungsvorrichtung 22 wird vorzugsweise ein Einzelspektrum als Hilfsspektrum ausgewählt und ebenfalls in Pixeltupel (x, y) umgerechnet. Daraus werden Darstellungsdaten berechnet und den zu dem Hilfsspektrum gehörenden Pixeltupeln eine Farbe für die Darstellung auf dem Bildschirm zugeordnet, die in der Farbskala zur Darstellung der Anzahl des Auftretens der Spektralwerte in der Akkumulationsvorrichtung 21 nicht vorkommen und die von den in der Farbskala vorkommenden Farben optisch deutlich unterscheidbar ist. Zusätzlich werden vorzugsweise die Pixelpunkte in der gleichen Farbe der Pixel des Hilfsspektrums angesteuert, welche zum Verbinden der Pixel des Hilfsspektrums durch Splines, Geraden oder sonstige Interpolationen nötig sind, um eine durchgezogenes Hilfsspektrum auf dem digitalen Bildschirm 15 darzustellen.

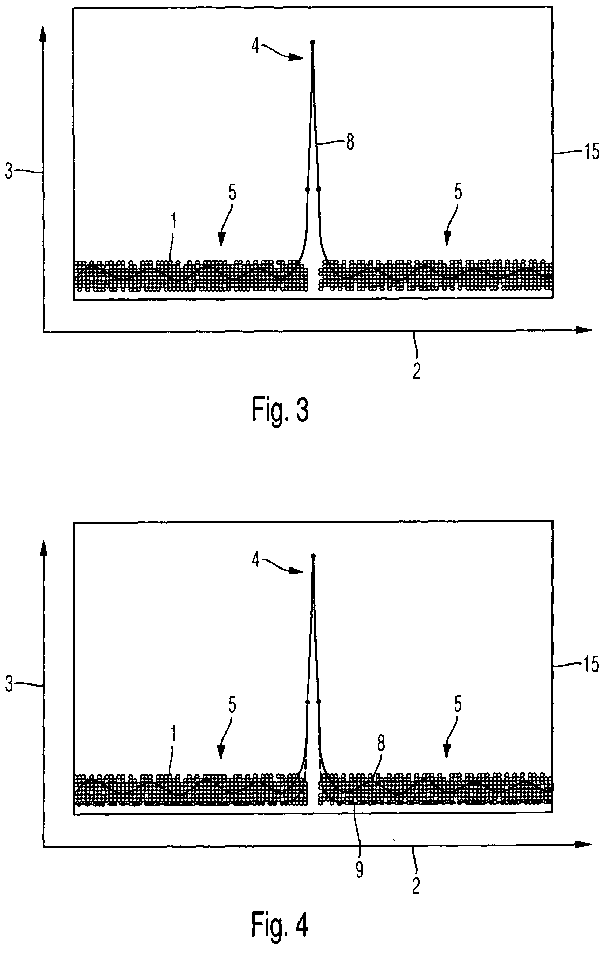

Die durch die Hilfsspektrumserzeugungsvorrichtung 22 berechneten Darstellungsdaten, die ein Hilfsspektrum zeigen, werden mittels einer Einkoppelvorrichtung 24 wieder mit den Darstellungsdaten der Akkumulationsvorrichtung 21 zusammengeführt. Die zusammengeführten Darstellungsdaten werden dann an den digitalen Bildschirm 15 zur Darstellung gegeben. Ein exemplarisches Darstellungsbild ist in Fig. 3 gezeigt.

Die akkumulierten Spektren sind in einer Darstellung der einzelnen Pixel 1 als Spektralwerte der Einzelspektren in einem Diagramm der logarithmierten Leistung 3 über die Frequenz 2 auf dem digitalen Bildschirm 15 aufgetragen. Die unterschiedliche Farbe der Pixel kann in dem schwarzweiß Bild nicht dargestellt werden und wird hier hilfsweise kurz beschrieben. In den Frequenzbereichen 5 mit niedrigen Leistungswerten sieht man ein stark fluktuierendes rauschartiges Signal, weshalb die Pixel 1 im Bereich 5 eine Farbe zeigen, die einer geringen Anzahl von sich wiederholenden Spektralwerten entspricht. Im Bereich 4 ist dagegen ein sehr schmalbandiges, stationäres und damit in vielen oder allen Einzelspektren vorhandenes Signal zu erkennen, da alle Spektralwerte in dem Frequenzbereich 4 sich auf die drei dargestellten Pixel der konkret ermittelten Spektralwerte in diesem Bereich konzentrieren. Dementsprechend werden diese drei Pixel 1 in einer Farbe dargestellt, die einer sehr hohen oder der höchsten Wiederholrate der Spektralwerte in den aufeinanderfolgenden Einzelspektren entspricht.

Allerdings sind so schmalbandige Spektrallinien in einer Punktdarstellung durch das menschliche Auge kaum erkennbar, da ein einzelner Pixelpunkt 1 nur die Fläche von 0,028 mm² bedeckt und so alleine kaum zu sehen ist. Wie bereits in der Einführung beschrieben ist die schmalbandige Spektrallinie zwar zu sehen, wenn alle Einzelspektren vektoriell dargestellt werden, was aber zu anderen ebenfalls beschriebenen Problemen führt.

Deshalb wird vorzugsweise ein Einzelspektrum als Hilfsspektrum 8 ausgewählt und zusätzlich in vektorieller Form auf den Bildschirm 15 gezeichnet. Somit kann einerseits die effektive und informationsreiche Punktdarstellung der gesammelten Einzelspektren erhalten bleiben und trotzdem stationäre Signalanteile 4 durch ein vektorielles Einzelspektrum 8 optisch einfach identifizierbar gemacht werden.

Dabei ist es bevorzugt, in der Einkoppelvorrichtung 24 die Darstellungsdaten der Akkumulationsvorrichtung 21 über die Darstellungsdaten der Hilfsspektrumsvorrichtung 22 zu legen, um weiterhin die Information der Häufigkeit des Auftretens eines Spektralwertes zu erhalten und in den Zwischenräumen der von der Punktdarstellung nicht angesteuerten Pixel, die vektorielle Darstellung des Einzelspektrums 8 zu zeigen. Andererseits ist die Überlagerung der Darstellungsdaten der Hilfsspektrumsvorrichtung 22 über die Darstellungsdaten der Akkumulationsvorrichtung 21 vorteilhaft, um einzelne rauschartige Signale oder Kurzzeitsignale mit niedriger Leistung im Frequenzbereich 5 darzustellen. Natürlich sind auch Mischformen denkbar, z.B. durch eine Teiltransparenz der überlagerten Darstellungsdaten.

Das Hilfsspektrum 8 ist dabei vorzugsweise ein aus den N letzten Einzelspektren gemitteltes Spektrum oder aus den seit der letzten Darstellungsdatenberechnung neu gemessenen Einzelspektren gemitteltes Spektrum oder vorzugsweise das neueste der gemessenen Einzelspektren. Dieses Einzelspektrum sollte in einer vorzugsweise bestimmbaren Rate durch ein neueres, vorzugsweise das neueste, Einzelspektrum ersetzt werden. Liegt diese Rate im Bereich des Auflösungsvermögens des menschlichen Auges, ca. 20 Bilder bzw. Hilfsspektren pro Sekunde, kann ein Optimum zwischen der Rechenlast der Berechnung der Darstellungsdaten und der Beobachtungsqualität der Dynamik des Hilfsspektrums 8 erreicht werden. Andererseits kann es auch vorteilhaft sein, eine sehr niedrige Erneuerungsrate für das Hilfsspektrum 8 oder ein festes Hilfsspektrum 8 zu wählen, um einen Vergleich mit einem Referenzspektrum zu schaffen. Als Hilfsspektrum 8 kommt auch ein aus allen N Einzelspektren oder Teilmengen daraus weiterverarbeitetes Hilfsspektrum 8 in Frage, wie zum Beispiel ein gemitteltes Spektrum oder ein Spektrum der maximalen oder minimalen Spektralwerte.

Vorzugsweise können in der Hilfsspektrumserzeugungsvorrichtung 22 auch mehrere Hilfsspektren ausgewählt werden und in optisch gut unterscheidbaren und von der Farbskala der Auftrittshäufigkeiten der Spektren unterschiedlichen Farben auf dem digitalen Bildschirm 15 dargestellt werden. Über eine Legende kann der Benutzer den verschiedenen Farben der Hilfsspektren die Art des jeweils einzelnen Hilfsspektrums entnehmen. Vorzugsweise handelt es sich um eine bestimmte Anzahl von in bestimmten Zeitabständen gemessenen Einzelspektren, wobei jeweils nach so einem bestimmten Zeitabstand das älteste Einzelspektrum durch ein aktuelles Einzelspektrum ersetzt wird. Durch eine zweite Farbskala, die die seit der Messung der angezeigten Hilfsspektren vergangene Zeit darstellt und von der ersten Farbskala optisch unterscheidbar ist, können die Einzelspektren über deren Farben eine Historie darstellen. Dadurch ist es auch nicht mehr notwendig die Hilfsspektren dynamisch zu aktualisieren, sondern kann die Spektren auch nur in gewissen Sprüngen aktualisieren, da die zeitliche Entwicklung durch mehrere statisch angezeigte Hilfsspektren dargestellt ist.

Fig. 4 zeigt ein solches Darstellungsbild mit zwei Hilfsspektren 8 und 9. Die beiden gemessenen Einzelspektren wären ohne die optisch unterschiedlich dargestellten Hilfsspektren in dem rauschartigen Signalanteil 5 nicht zu erkennen. Durch die Darstellung zweier zeitverschoben aufgenommener Einzelspektren 8 und 9 als Hilfsspektren lässt sich mit einem Blick erkennen, dass sich das Spektrum des Messsignals im Bereich 5 über die Zeit ändert.

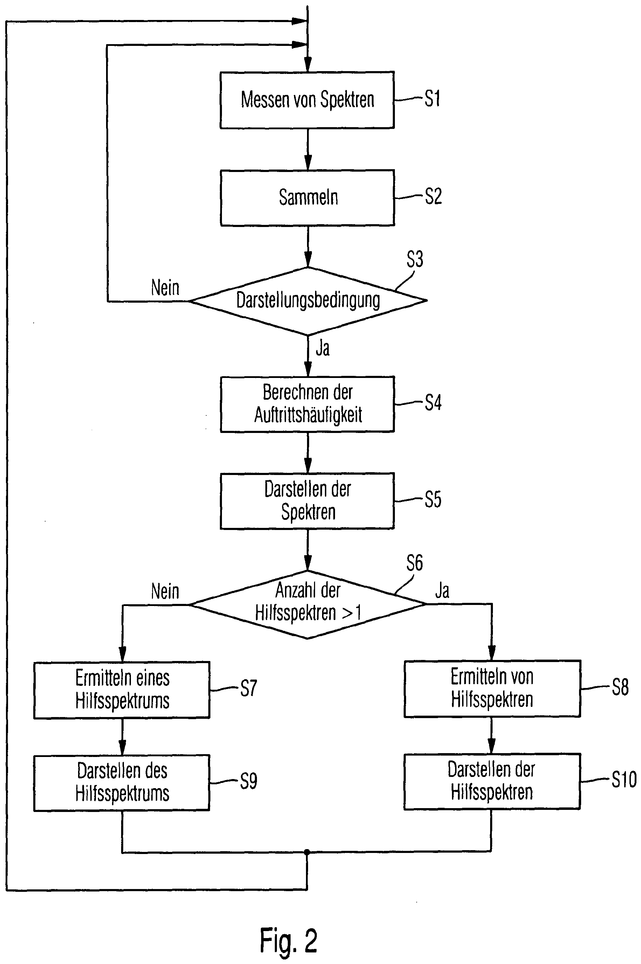

Fig. 2 zeigt die einzelnen Verfahrenschritte eines Ausführungsbeispiels des erfindungsgemäßen Verfahrens. In einem ersten Schritt S1 wird ein Einzelspektrum wie zuvor bezüglich der Messvorrichtung 12 beschrieben gemessen. In einem zweiten Schritt S2 wird in der Akkumulationsvorrichtung 21 der Steuervorrichtung 20 das gemessene Einzelspektrum gespeichert. Ist bereits eine bestimmte Anzahl N an Einzelspektren gespeichert, wird das älteste Einzelspektrum gelöscht und das neue hinzugefügt.

In einem dritten Schritt S3 wird getestet, ob eine Darstellungsbedingung erfüllt ist. Eine solche Darstellungsbedingung kann am Anfang des Verfahrens zum Beispiel die Speicherung einer bestimmten Anzahl N von Spektren sein. Im Betrieb könnte die Darstellungsbedingung eine seit der letzten erfüllten Darstellungsbedingung vergangenen Zeit oder seit der letzten erfüllten Darstellungsbedingung neu gemessene und gespeicherte Einzelspektren sein. Ist die Darstellungsbedingung nicht erfüllt, werden Schritt S1, S2 und S3 wiederholt bis in S3 die Darstellungsbedingung erfüllt ist.

Ist die Darstellungsbedingung erfüllt, wird in Schritt S4 in der Akkumulationsvorrichtung 21 die Auftrittshäufigkeit jedes Spektralwerts in der Gesamtheit der verschiedenen Spektren ermittelt. In Schritt S5 werden alle gespeicherten Einzelspektren in einer Punktdarstellung auf dem digitalen Bildschirm 15 dargestellt, wobei die Farbe der dargestellten Punkte der Spektralwerte der Anzahl ihres Auftretens in der Gesamtheit der verschiedenen Einzelspektren entspricht.

In Schritt S6 wird aufgrund von Benutzereinstellungen entschieden, ob ein oder mehrere Hilfsspektren dargestellt werden. Wird nur ein Hilfsspektrum 8 ermittelt, wird in Schritt S7 aus einem oder mehreren der Einzelspektren ein Hilfsspektrum 8 ermittelt. Vorzugsweise ist das Hilfsspektrum 8 das neueste gemessene Einzelspektrum. Das ermittelte Hilfsspektrum S9 wird auf dem Bildschirm 15 in einer optisch gut von den anderen Spektren unterscheidbaren Farbe dargestellt. Vorzugsweise wird das Hilfsspektrum 8 interpoliert dargestellt.

Wird in Schritt S6 festgestellt, dass mehrere Hilfsspektren 8 und 9 dargestellt werden sollen, werden diese Hilfsspektren 8 und 9 in Schritt S8 ermittelt und in Schritt S10 auf dem digitalen Bildschirm 15 dargestellt.

Nach dem Schritt S9 oder S10 wird die Prozedur von Schritt S1 aus wiederholt, bis das Verfahren durch den Benutzer oder eine sonstige Endroutine, z.B. bei Ablauf einer vorgegebenen Messzeit, beendet wird. In dem Ausführungsbeispiel wurde die Erneuerungsrate des Hilfsspektrums 8 der Darstellungsrate der gesammelten Spektren gleichgesetzt. Dies kann vorteilhaft sein, ist aber nicht einschränkend für die Erfindung.

Die Erfindung ist nicht auf das dargestellte Ausführungsbeispiel beschränkt. Vielmehr sind auch einzelne Merkmale der erfindungsgemäßen Messvorrichtung und des erfindungsgemäßen Verfahrens in vorteilhafter Weise kombinierbar.

## Patentansprüche

1. Verfahren zur Messdatenverarbeitung aufweisend die folgenden Schritte:
- Messen einer Mehrzahl von Einzelspektren eines Signals in einem bestimmten Zeitintervall (S1);
- gleichzeitiges Darstellen der Einzelspektren auf einer Anzeigevorrichtung (S5) und optisch unterscheidbares Darstellen der auftretenden Spektralwerte (1) in Abhängigkeit der Anzahl ihres Auftretens in der Gesamtheit der verschiedenen Einzelspektren (S4);
wobei ein Hilfsspektrum (8) aus einem oder mehreren der Einzelspektren gebildet wird (S7) und das Hilfsspektrum (8) auf der Anzeigevorrichtung (15) optisch unterscheidbar zu den gleichzeitig dargestellten Einzelspektren dargestellt wird (S9);
**dadurch gekennzeichnet,**
**dass** die Spektralwerte der gleichzeitig dargestellten Einzelspektren jeweils als Punkte (1) über die Frequenz dargestellt werden und die Anzahl des Auftretens der Spektralwerte (1) in der Gesamtheit der verschiedenen Einzelspektren durch eine Farbskala dargestellt wird und das Hilfsspektrum (8) in einer nicht in der Farbskala der Spektralwertehäufigkeit vorkommenden Farbe dargestellt wird,
**dass** das Hilfsspektrum (8) ein gemessenes Einzelspektrum der Mehrzahl der gemessenen Einzelspektren ist oder, bei einer Mehrzahl von Hilfsspektren, die Hilfsspektren (8, 9) gemessene Einzelspektren sind, deren Farben den seit deren Messung vergangen Zeiten entsprechen, und
**dass** die Darstellungspunkte des Hilfsspektrums (8) interpoliert werden.

2. Verfahren nach Anspruch 1,
**dadurch gekennzeichnet,**
**dass** eine Anzahl Hilfsspektren (8, 9) gleichzeitig dargestellt ist, die größer als 1 ist.

3. Verfahren nach Anspruch 2,
**dadurch gekennzeichnet,**
**dass** die einzelnen, gleichzeitig dargestellten Hilfsspektren (8, 9) optisch unterscheidbar dargestellt sind.

4. Verfahren nach einem der Ansprüche 1 bis 3,
**dadurch gekennzeichnet,**
**dass** die Mehrzahl der gemessenen Einzelspektren der Messvorrichtung eine Mehrzahl zeitlich nacheinander gemessener Spektren ist.

5. Messvorrichtung aufweisend
- eine Messvorrichtung (12) zum Messen einer Mehrzahl von Einzelspektren eines Signals;
- eine Anzeigevorrichtung (15) zur Darstellung von Spektralwerten über der Frequenz;
- eine Akkumulationsvorrichtung (21) verbunden mit der Anzeigevorrichtung (15) und der Messvorrichtung (12) zur Berechnung von Darstellungsdaten aus den gemessenen Einzelspektren der Messvorrichtung (12),
wobei die Akkumulationsvorrichtung (21) mehrere Einzelspektren aus einem bestimmten Zeitbereich sammelt und Darstellungsdaten aus den Einzelspektren für die Anzeigevorrichtung (15) berechnet, so dass die mehreren Einzelspektren aus dem bestimmten Zeitbereich auf der Anzeigevorrichtung (15) gleichzeitig darstellbar sind und die auftretenden Spektralwerte (1) verschiedener Einzelspektren in Abhängigkeit von der Anzahl ihres Auftretens in der Gesamtheit der Einzelspektren optisch unterscheidbar dargestellt sind;
- eine Auskoppelvorrichtung (23) zur Auskoppelung von wenigstens einem der Einzelspektren der Messvorrichtung (12) vor der Akkumulationsvorrichtung (21);
- eine Hilfsspektrumserzeugungsvorrichtung (22) verbunden mit der Auskoppelvorrichtung (23) zum Bilden eines Hilfsspektrums (8) aus dem einen oder den mehreren der Einzelspektren und zur Berechnung von Darstellungsdaten aus dem Hilfsspektrum (8), so dass das Hilfsspektrum (8) auf der Anzeigevorrichtung (15) optisch unterscheidbar zu den gleichzeitig dargestellbaren Einzelspektren darstellbar ist, und
- eine Einkoppelvorrichtung (24) angeordnet zwischen der Akkumulationsvorrichtung (21) und der Anzeigevorrichtung (15) und verbunden mit der Hilfsspektrumserzeugungsvorrichtung (22) zum Zusammenführen der Darstellungsdaten des Hilfsspektrums (8) mit den Darstellungsdaten des Hilfsspektrums;
**dadurch gekennzeichnet,**
**dass** mit der Akkumulationsvorrichtung (21) die Einzelspektren jeweils als Punkte (1) über die Frequenz (2) gleichzeitig dargestellt werden und die Anzahl des Auftretens der Spektralwerte in der Gesamtheit der verschiedenen Einzelspektren durch eine Farbskala dargestellt wird und dass mit der Hilfsspektrumserzeugungsvorrichtung (22) das Hilfsspektrum in einer nicht in der Farbskala für die Spektralwerte vorkommenden Farbe dargestellt wird, dass mit der Hilfsspektrumsvorrichtung (22) ein gemessenes Einzelspektrum der Mehrzahl Spektren als Hilfsspektrum (8) ausgewählt wird oder mehrere gemessene Einzelspektren als Hilfsspektren (8, 9), deren Darstellungsfarben oder Darstellungsmuster den seit deren Messung vergangen Zeiten entsprechen, ausgewählt werden, und dass mit der Hilfsspektrumserzeugungsvorrichtung (22) die Darstellungspunkte des Hilfsspektrums (8) interpoliert werden.

6. Messvorrichtung nach Anspruch 5,
**dadurch gekennzeichnet,**
**dass** mit der Hilfsspektrumserzeugungsvorrichtung (22) eine Anzahl Hilfsspektren (8, 9) gleichzeitig darstellbar sind, die größer als 1 ist.

7. Messvorrichtung nach Anspruch 6,
**dadurch gekennzeichnet,**
**dass** mit der Hilfsspektrumserzeugungsvorrichtung (22) die Hilfsspektren (8, 9) optisch unterscheidbar darstellbar sind.

8. Messvorrichtung nach Anspruch 6 oder 7,
**dadurch gekennzeichnet,**
**dass** mit der Messvorrichtung (12) Einzelspektren zeitlich nacheinander messbar sind.

## Claims

1. Method for processing measurement data comprising the following steps:
- measuring of a plurality of individual spectra of a signal in a particular interval of time (S1);
- simultaneous displaying of the individual spectra on a displaying device (S5) and optically distinguishable displaying of the spectral values (1) occurring dependent on the number of their occurrences in the totality of the different individual spectra (S4);
wherein an auxiliary spectrum (8) is formed from one or more of the individual spectra (S7) and the auxiliary spectrum (8) is displayed on the displaying device (15) so as to be optically distinguishable from the individual spectra displayed simultaneously (S9);
**characterised in that**
the spectral values of the individual spectra displayed simultaneously are each displayed as points (1) over the frequency and the number of the occurrences of the spectral values (1) in the totality of the different individual spectra is displayed by a colour scale and the auxiliary spectrum (8) is displayed in a colour which does not occur in the colour scale of the frequency of occurrence of the spectral values,
**in that** the auxiliary spectrum (8) is a measured individual spectrum of the plurality of the measured individual spectra or in the case of a plurality of auxiliary spectra the auxiliary spectra (8, 9) are measured individual spectra the colours of which correspond to the times which have elapsed since their measurement, and
**in that** the display points of the auxiliary spectrum (8) are interpolated.

2. Method according to claim 1,
**characterised in that**
a number of auxiliary spectra (8, 9) which is greater than 1 are displayed simultaneously.

3. Method according to claim 2,
**characterised in that**
the individual auxiliary spectra (8, 9) displayed simultaneously are displayed so as to be optically distinguishable.

4. Method according to one of claims 1 to 3,
**characterised in that**
the plurality of the measured individual spectra of the measuring device is a plurality of spectra measured sequentially in time.

5. Measuring device comprising
- a measuring device (12) for measuring of a plurality of individual spectra of a signal;
- a displaying device (15) for displaying of spectral values over the frequency;
- an accumulating device (21) connected with the displaying device (15) and the measuring device (12) for calculation of display data from the measured individual spectra of the measuring device (12),
wherein the accumulating device (21) collects a plurality of individual spectra from a particular time range and calculates display data from the individual spectra for the displaying device (15) so that the plurality of individual spectra from the particular time range can be displayed on the displaying device (15) simultaneously and the spectral values (1) occurring of different individual spectra are displayed so as to be optically distinguishable dependent on the number of their occurrences in the totality of the individual spectra;
- an extracting device (23) for extraction of at least one of the individual spectra of the measuring device (12) before the accumulating device (21);
- an auxiliary spectrum generating device (22) connected with the extracting device (23) for forming of an auxiliary spectrum (8) from the one or more of the individual spectra and for calculation of display data from the auxiliary spectrum (8) so that the auxiliary spectrum (8) can be displayed on the displaying device (15) so as to be optically distinguishable from the individual spectra which can be displayed simultaneously, and
- a coupling device (24) arranged between the accumulating device (21) and the displaying device (15) and connected with the auxiliary spectrum generating device (22) for combining the display data of the auxiliary spectrum (8) with the display data of the auxiliary spectrum;
**characterised in that**
with the accumulating device (21) the individual spectra are in each case displayed simultaneously as points (1) over the frequency (2) and the number of the occurrences of the spectral values in the totality of the different individual spectra is displayed by a colour scale and
**in that** with the auxiliary spectrum generating device (22) the auxiliary spectrum is displayed in a colour which does not occur in the colour scale for the spectral values,
**in that** with the auxiliary spectrum generating device (22) a measured individual spectrum of the plurality of spectra is selected as the auxiliary spectrum (8) or
a plurality of measured individual spectra are selected as the auxiliary spectra (8, 9) the display colours or display patterns of which correspond to the times which have elapsed since their measurement, and
**in that** with the auxiliary spectrum generating device (22) the display points of the auxiliary spectrum (8) are interpolated.

6. Measuring device according to claim 5,
**characterised in that**
with the auxiliary spectrum generating device (22) a number of auxiliary spectra (8, 9) which is greater than 1 can be displayed simultaneously.

7. Measuring device according to claim 6,
**characterised in that**
with the auxiliary spectrum generating device (22) the auxiliary spectra (8, 9) can be displayed so as to be optically distinguishable.

8. Measuring device according to claim 6 or 7,
**characterised in that**
with the measuring device (12) individual spectra can be measured sequentially in time.

## Revendications

1. Procédé de traitement de données de mesure comprenant les étapes suivantes :
- la mesure d'une pluralité de spectres individuels d'un signal dans un intervalle de temps (S1) défini ;
- la représentation simultanée des spectres individuels sur un dispositif d'affichage (S5) et la représentation différentiable optiquement des valeurs spectrales (1) apparaissant en fonction du nombre de leur occurrence dans la totalité des différents spectres individuels (S4) ;
dans lequel un spectre auxiliaire (8) est formé à partir d'un ou de plusieurs des spectres individuels (S7) et le spectre auxiliaire (8) est représenté (S9) sur le dispositif d'affichage (15) de manière différentiable optiquement des spectres individuels représentés simultanément (S9) ;
**caractérisé**
**en ce que** les valeurs spectrales des spectres individuels représentés simultanément sont représentées chacune sous la forme de points (1) par rapport à la fréquence et le nombre d'occurrences des valeurs spectrales (1) dans la totalité des différents spectres individuels sont représentées par une échelle de couleurs et le spectre auxiliaire (8) est représenté dans une couleur non présente dans l'échelle de couleurs de la fréquence des valeurs spectrales,
**en ce que** le spectre auxiliaire (8) est un spectre individuel mesuré de la pluralité des spectres individuels mesurés ou, dans le cas d'une pluralité de spectres auxiliaires, les spectres auxiliaires (8, 9) sont des spectres individuels mesurés dont les couleurs correspondent aux temps passés depuis leur mesure, et
**en ce que** les points de représentation du spectre auxiliaire (8) sont interpolés.

2. Procédé selon la revendication 1,
**caractérisé**
**en ce qu'**un certain nombre de spectres auxiliaires (8, 9) sont représentés simultanément, lequel nombre est supérieur à 1.

3. Procédé selon la revendication 2,
**caractérisé**
**en ce que** les différents spectres auxiliaires (8, 9) représentés simultanément sont représentés de manière différentiable optiquement.

4. Procédé selon l'une quelconque des revendications 1 à 3,
**caractérisé**
**en ce que** la pluralité des spectres individuels mesurés du dispositif de mesure est une pluralité de spectres mesurés successivement dans le temps.

5. Dispositif de mesure comprenant
- un dispositif de mesure (12) destiné à mesurer une pluralité de spectres individuels d'un signal ;
- un dispositif d'affichage (15) destiné à représenter des valeurs spectrales par rapport à la fréquence ;
- un dispositif d'accumulation (21) relié au dispositif d'affichage (15) et au dispositif de mesure (12) pour le calcul de données de représentation à partir des spectres individuels mesurés du dispositif de mesure (12),
dans lequel le dispositif d'accumulation (21) collecte plusieurs spectres individuels à partir d'une plage temporelle définie et calcule les données de représentation à partir des spectres individuels pour le dispositif d'affichage (15), de sorte que les différents spectres individuels provenant de la plage temporelle définie peuvent être représentés simultanément sur le dispositif d'affichage (15) et que les valeurs spectrales (1) apparaissant de différents spectres individuels sont représentées de manière différentiable optiquement en fonction du nombre de leur occurrence dans la totalité des spectres individuels ;
- un dispositif d'extraction (23) destiné à extraire au moins un des spectres individuels du dispositif de mesure (12) devant le dispositif d'accumulation (21) ;
- un dispositif de génération de spectre auxiliaire (22) relié au dispositif d'extraction (23) pour former un spectre auxiliaire (8) à partir du ou des différents spectres individuels et pour calculer des données de représentation à partir du spectre auxiliaire (8), de sorte que le spectre auxiliaire (8) peut être représenté sur le dispositif d'affichage (15) de manière différentiable optiquement des spectres individuels pouvant être représentés simultanément, et
- un dispositif d'injection (24) agencé entre le dispositif d'accumulation (21) et le dispositif d'affichage (15) et relié au dispositif de génération de spectre auxiliaire (22) pour réunir les données de représentation du spectre auxiliaire (8) aux données de représentation du spectre auxiliaire ;
**caractérisé**
**en ce que**, au moyen du dispositif d'accumulation (21), les spectres individuels sont représentés simultanément respectivement sous la forme de points (1) par rapport à la fréquence (2) et le nombre d'occurrences des valeurs spectrales dans la totalité des différents spectres individuels sont représentés par une échelle de couleurs et en ce que, au moyen du dispositif de génération de spectre auxiliaire (22), le spectre auxiliaire est représenté dans une couleur non présente dans l'échelle de couleurs pour les valeurs spectrales,
**en ce que**, au moyen du dispositif de génération de spectre auxiliaire (22), un spectre individuel mesuré de la pluralité de spectres est sélectionné comme spectre auxiliaire (8) ou plusieurs spectres individuels mesurés, dont les couleurs de représentation ou les motifs de représentation correspondent aux temps passés depuis leur mesure, sont sélectionnés comme spectres auxiliaires (8, 9), et
**en ce qu'**au moyen du dispositif de génération de spectre auxiliaire (22), les points de représentation du spectre auxiliaire (8) sont interpolés.

6. Dispositif de mesure selon la revendication 5,
**caractérisé**
**en ce que**, au moyen du dispositif de génération de spectre auxiliaire (22), un certain nombre de spectres auxiliaires (8, 9) peuvent être représentés simultanément, lequel nombre est supérieur à 1.

7. Dispositif de mesure selon la revendication 6,
**caractérisé**
**en ce que**, au moyen du dispositif de génération de spectre auxiliaire (22), les spectres auxiliaires (8, 9) peuvent être représentés de manière différentiable optiquement.

8. Dispositif de mesure selon la revendication 6 ou 7,
**caractérisé**
**en ce que**, au moyen du dispositif de mesure (12), les spectres individuels peuvent être mesurés successivement dans le temps.
